(19) Europäisches Patentamt
European Patent Office
Office européen des brevets

(11) **EP 1 865 562 A2**

(12) **EUROPEAN PATENT APPLICATION**

(43) Date of publication:
**12.12.2007 Bulletin 2007/50**

(51) Int Cl.:
**H01L 31/0216** (2006.01)   **H01L 31/0232** (2006.01)

(21) Application number: **07109624.2**

(22) Date of filing: **05.06.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **06.06.2006 CN 200610083853**

(71) Applicant: **Lo, Wei-Hung**
**Songshan Distr., Taipei City (TW)**

(72) Inventor: **Naum, Soshchin**
**Changhua County 500 (TW)**

(74) Representative: **Viering, Jentschura & Partner**
**Grillparzerstrasse 14**
**81675 München (DE)**

(54) **A solar cell and a spectrum converter**

(57) The present invention discloses a solar cell and a spectrum converter. By moving the emission spectrum between the peak wavelength of the solar radiation ($\lambda$ = 470 nm) and the highest photosensitivity of monocrystalline silicon ($\lambda$ = 860~ 880 nm), the efficiency of a solar cell can usually reach 14-16%. The present invention provides a spectrum converter to move the short wavelength and visible light of the solar radiation to the range of infrared and red light. The spectrum converter is based on fluorescent powder particles of garnet-structure oxides of elements of the II, III, and IV groups, and uses elements in the III ($Ce^{+3}$), IV ($Cr^{+3}$), VIII groups as exciting agents. The chemical composition of the fluorescent powder is $(Y,Gd)_3Al_{5-x}(Mg,Si)_xO_{12}$(x=0~3), wherein the actual position of the emission spectrum of the fluorescent powder being moved to between the range of 535 and 780 nm is determined by the ratio of Y, Gd, Mg, and Si. The spectrum converter comprises an organic polymer uniformly filled with super-dispersion fluorescent particles, whose average diameter is 0.5~0.8 $\mu$m. The solar cell according to the present invention can achieve an efficiency up to 18~18.7% in full operation.

FIG. 4

## Description

### FIELD OF THE INVENTION

The present invention relates a solar cell and a spectrum converter and in particular to a spectrum converter to convert the short-wavelength and visible wave of sun light into infrared and red light, and provides the efficiency of the solar cell up to 18-18.7% when fully operated.

### BACKGROUND OF THE INVENTION

The simplest solar cell of using monocrystalline silicon to convert solar radiation into usable energy is described below. The solar cell is based on monocrystalline silicon, usually a p-type semi-conductive monocrystalline silicon wafer, which is realized by doping boron compound into the monocrystalline silicon. Gaseous antimony doped in p-type thin film usually diffuse and form p-n junction on the silicon surface, changing the conducting species from holes into electrons, i.e. a n-type junction. The thickness of n-type deposition on silicon wafer is 0.5-3 $\mu$m. The thin film usually connects to a metal electrode (gold or its alloy). The back of the silicon wafer is completely covered with a metal electrode or electrode of silver deposition.

The physics principle of solar cell is described below. When the device is excited by the radiation of sun or artificial light, the photons absorbed by silicon result in unbalanced hole-electron pairs. At this moment, the electrons in the p-layer close to the p-n junction will drift to the boundary and be attracted into the n-type junction by the electric field; on the other hand, the holes carrier (p-type carriers) in the n-type junction on the silicon wafer surface partially drift into the silicon wafer interior, i.e. the p-type junction. This drifts results in the n-type junction gains extra negative charges and p-type junction gains extra positive charges. Thus the contact potential difference of p-type junction and n-type junction reduces, leading to a voltage in the outside circuit. The semiconductor power source has the n-type junction as the cathode and p-type junction as the anode.

The photoelectric effect occurring on silicon wafer under light can be described by volt-ampere characteristics equation:

$$U=(KT/q) \times \ln[(I_{ph}-I)/I_S+I_z]$$

where Is is the current supplied and $I_{ph}$ is the photoelectric current.

The maximum power from the semiconductor per millimeter square is $I_{ph} \times U = X \times I_{K3} \times U_{XX}$, where X is the proportional constant of volt-ampere characteristics, $I_{K3}$ is the short-circuit current, and $U_{XX}$ is the floating voltage. The effective working efficiency of the simplest solar cell structure described above is 15-16%, while a silicon wafer of semiconductor solar cell can convert solar radiation to obtain to 40 W of power.

The major drawback of the solar cell structure is the non-uniform thickness of p-type and n-type layers; also, the maximum spectrum of more active p-n junction and silicon usually doesn't correspond to that of the solar radiation.

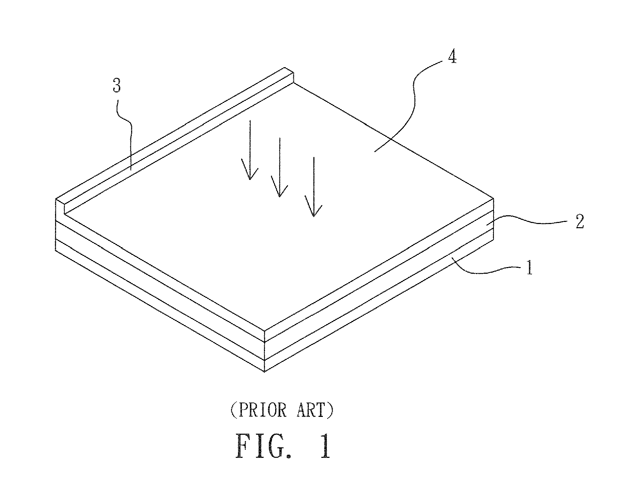

The following figures are used to explain the deviation. FIG. 1 shows that the basic framework of a conventional solar cell, wherein 1 is a P-type monocrystalline silicon wafer, 2 is a n-type junction, 3 is an electrode system, and 4 is an outer anti-reflection coating. The silicon wafer of the solar cell is usually packed with dustproof housing made of vinyl acetate or polycarbonate-like compound.

According to the solar radiation spectrum measured in the medium latitude region (such as at northern latitude 48°), when the sun is 45° above the horizon, the maximum-energy wavelength of the solar spectrum reaching the earth surface is between 290-1060 nm. (It is worth noting that, when a solar cell works in the near-space environment, the complete spectrum also contains the short-wavelength radiation of UV and VUV and the medium wavelength radiation of far-red longer than 1065 nm; on the other hand, when a solar cell works on the earth surface, the short-wave radiation will be absorbed by oxygen in the atmosphere, and the short-wave radiation of UV will be largely absorbed by vapors).

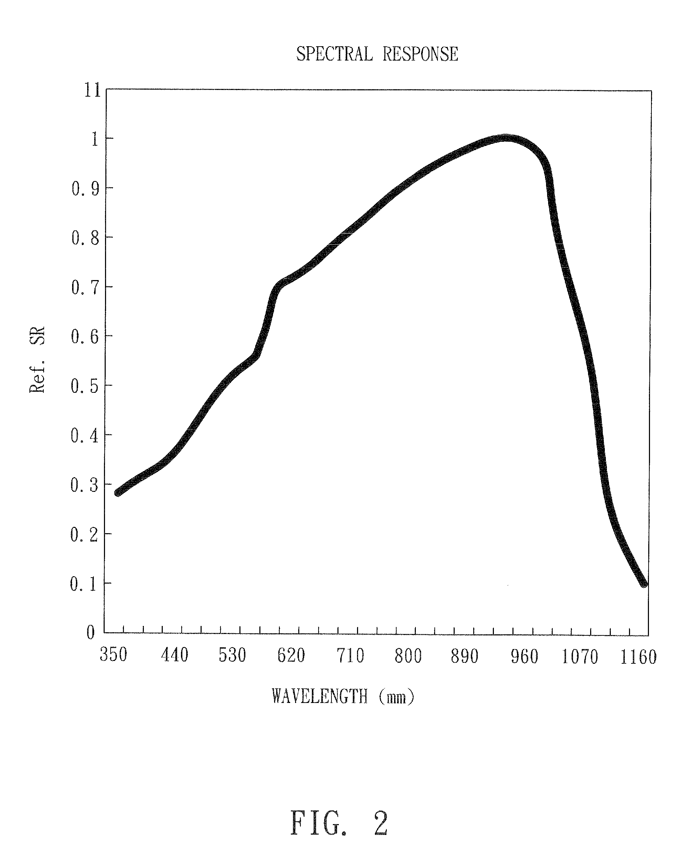

It is also noting that that the energy distribution of the solar radiation spectrum is uneven. The maximum energy of the solar radiation appears in the blue light ($\lambda$ = 470 nm). The solar radiation is reduced by 40% in the main section of visible light between 500-600 nm, and the corresponding radiation is half at $\lambda$ = 720 nm. Furthermore, the radiation at $\lambda$ = 1000 nm = 1 $\mu$m is only 1/5 of the maximum value. Figure 2 shows the sensitivity of the standard spectral curve of a solar cell sample at each wavelength range corresponding to the solar spectrum. Compared the data of the solar radiation energy spectrum with the data in figure 2, it can be found that, at the highest radiation zone between $\lambda$ = 400 ~ 470 nm, the maximum sensitivity of monocrystalline silicon is no greater than 20% of the maximum sensitivity. In the spectrum range of $\lambda$ = 440 ~ 880 nm, the sensitivity rises dramatically; that is, the monocrystalline silicon in a solar cell is more sensitive to visible and IR radiation than others. However, the maximum sensitivity of the IM125 solar cell is close to the wavelength range of 950 ~ 980 nm. The aforementioned narrow range of the maximum sensitivity of a monocrystalline silicon solar cell is determined by the energy bandgap of the monocrystalline silicon, whose bandgap width is Eg=1.21 ev and its corresponding wavelength is $\lambda$ = 950 nm.

From the comparison of the solar radiation spectrum and the sensitivity of monocrystalline silicon in a solar cell, the following conclusions can be drawn:

1. The corresponding wavelength difference between the peak solar radiation and the maximum sensitivity of a solar cell is $\Delta\lambda$ = 500 nm, and the corresponding energy difference is $\Delta E$=0.42ev;
2. The higher energy wavelength range between 380 ~ 450 nm of the solar radiation does not correspond well the sensitivity of a monocrystalline silicon;
3. The peak wavelength of the solar radiation is almost twice as that of the greatest sensitivity of a monocrystalline silicon.

These important conclusions related to physics principles determine the main drawbacks of the existing monocrystalline silicon in the solar cell:

1. The effective efficiency of the solar cell is very low, wherein the theoretical maximum is determined by the integral of the solar radiation energy and spectrometric sensitivity of monocrystalline silicon; the value is no greater than 28-30%.
2. The peak wavelength of the medium solar radiation is between $\lambda$= 470-620 nm, wherein the exciting effect of a monocrystalline silicon is quite weak. The photon of the solar radiation absorbed by a solar cell, the excessive energy will induce phonon radiation, producing phonons of $hv$=500cm$^{-1}$ (~0.1ev) and in turn increasing the temperature of a solar cell. During this process, the bandgap width of silicon will be reduced to about 0.01ev/□, while the wavelength moves toward the longer wavelength range (980~1020 nm), corresponding to the greatest sensitivity of a monocrystalline silicon of the solar cell. However, vapors in the atmosphere can significantly affect the solar radiation in the wavelength range.
3. In a solar cell, the energy of the short-wave solar radiation between $\lambda$ = 2.5~3ev will induce irreversible defects. The vacancies generated at wave nodes and atoms formed between wave nodes will reduce the efficiency for the blocking layer of a solar cell.

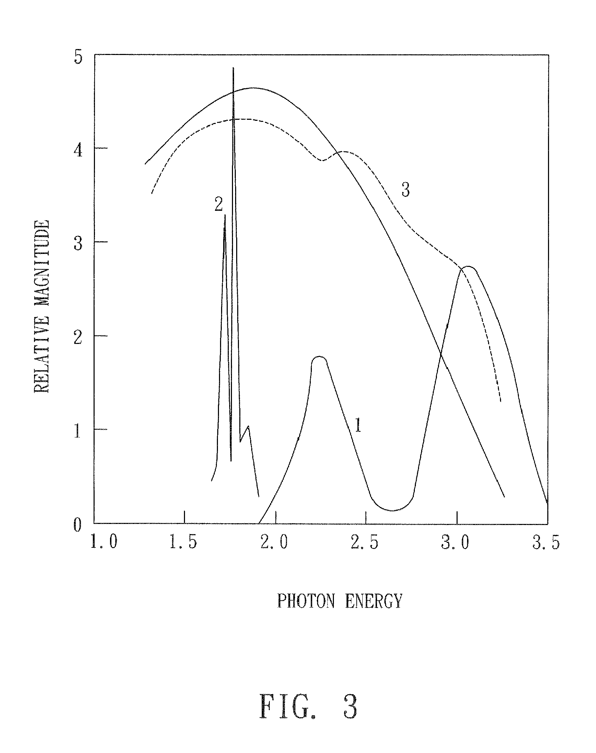

These deviations prevent a solar cell from achieving the described working efficiency of 15-16%. For a long time, researchers and producers have strived to overcome the defects and limitations described above. Chopr disclosed a solution in his article "Thin Film Solar Cells" (pages 378-379, World Publish Ltd.), from which we developed a prototype. Figure 3 shows a solar cell covered with a layer of monocrystalline ruby, which can enhance the absorption of the solar radiation in the range of 2.3ev~3.2ev. The physical significance of this design is that, by coating the solar cell with a layer of monocrystalline ruby, the absorption of the solar radiation in the range of 2.3ev~3.2ev will be enhanced, and the Cr$^{+3}$ will be excited to induce d-d transitions and then cause the narrow-band to emit light. Consequently, the peak wavelength of Cr$^{+3}$ in the solar radiation in the ruby corresponds to $\lambda$=695nm, and thus the original solar radiation moves to longer wavelength, and the short-wavelength radiation completely shifts to the wavelength range of $\lambda$=700 nm.

In Figure 3, the plot of photon energy verse absorptivity, curve 2 is the absorptivity of the excited Cr$^{+3}$, and curve 1 is the light emitting of a monocrystalline ruby. Figure 3 is also marked with the carrier assembly coefficient (curve 3) of a monocrystalline silicon cell coated with an excitable ruby and the coefficient varies with whether the ruby layer is present. It is obvious that the carrier assembly coefficient of the directly excited short wavelength of the solar radiation is 10-20% higher than that of a light-emitting device operated by a ruby converter. The author of the article thus concluded that the efficiency of a monocrystalline silicon solar cell may still rise by 0.5-2% with a ruby converter. Although some practical improvements have been made in the field of solar cell techniques, some drawbacks still exist:

1. The excited spectrum of ruby ($Al_2O_3 \cdot Cr$) does not completely correspond to the sensitivity curve of the monocrystalline silicon solar cell.
2. The cost of the device using monocrystalline ruby is high..

**SUMMARY OF THE INVENTION**

To overcome the drawbacks of conventional arts, the primary objective of the present invention is to provide a solar cell and a spectrum converter, which uses a broadband spectrum converter to enhance the absorption of the visible light up to 80%.

Another objective of the present invention is to provide a solar cell and a spectrum converter, wherein the spectrum converter emits lights not in the narrowband range, but in the energy-concentrated range of $\lambda$=580-760 nm.

Yet another objective of the present invention is to provide a solar cell and a spectrum converter, wherein the spectrum converter has higher converting efficiency with a higher photon radiation up to 96%.

Still yet another objective of the present invention is to provide a solar cell and a spectrum converter, wherein the spectrum converter is filled with polymer thin film made of super-dispersion inorganic fluorescent powder and the thin film is contacted directly to the outer surface of p-type monocrystalline silicon; the technical scheme is characterized by converting more than 16% solar radiation into electricity.

Still another the objective of the present invention is to provide a solar cell, comprising: a monocrystalline silicon wafer to accommodate the spectrum converter described later, and a spectrum converter manufactured to be a polymer thin film, wherein the polymer thin film is filled with inorganic fluorescent powder and in contact with the outer layer of the monocrystalline silicon wafer, which can enhance the absorption of a first specific wavelength of solar radiation and re-radiate into a second specific wavelength of radiation.

To achieve the objectives described above, the spectrum converter according to the present invention is used in a solar cell, which is a polymer thin film made of inorganic powders and in contact with the outer surface of a monocrystalline silicon wafer, to enhance the absorption of a first specific wavelength of solar radiation and re-radiate into a second specific wavelength of radiation.

## BRIEF DESCRIPTION OF THE DRAWINGS

The present invention can be more fully understood by reference to the following description and accompanying drawings, in which:

FIG. 1 schematically illustrates the basic framework of a conventional solar cell.
FIG. 2 schematically illustrates the sensitivity of the standard spectral curve of a solar cell sample at each wavelength range corresponding to the solar spectrum;
FIG. 3 schematically illustrates a solar cell covered with a layer of monocrystalline ruby, which can enhance the absorption of the solar radiation in the range of 2.3ev~3.2ev; and
FIG. 4 schematically illustrates the structure of the solar cell according to the present invention.

## DETAILED DESCRIPTION OF THE PREFERRED EMBODIMENTS

Thus far, there has been no experimental data approaching the highest efficiency of a solar cell. The solar cell based on monocrystalline silicon and spectrum converter can achieve the efficiency. The spectrum converter is made of polymer using polycarbonate, and/or polysiloxanes, and/or acrylatepolymer as its substrate, in which is filled with the fluorescent powder made of garnet-structure oxides of II, III, and IV group elements with diameters less than the peak wavelengths of the emitted radiation; the filling ratio of fluorescent powder particle in the polymer is 1-50%.

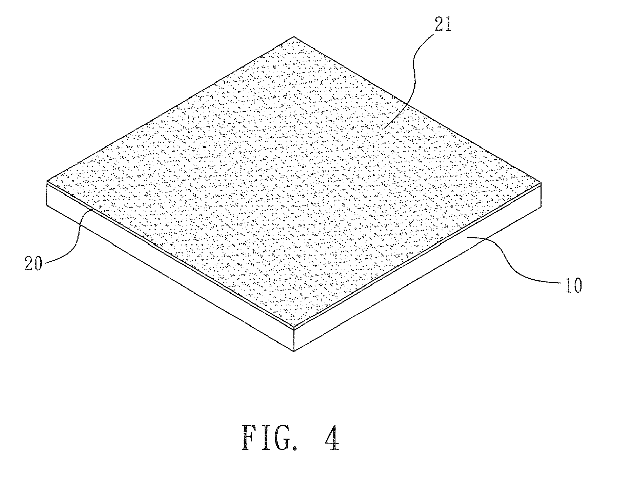

FIG. 4 schematically illustrates the structure of the solar cell according to the present invention, comprising a silicon wafer 10 and a spectrum converter 20.

Wherein the silicon wafer 10 is, for example but not limited to, a p-type monocrystalline silicon wafer, a p-type polycrystalline silicon wafer, a n-type monocrystalline silicon wafer, or a n-type polycrystalline silicon wafer. In the present embodiment, for example but not limited to, a p-type monocrystalline silicon wafer is chosen as an example for explanation. Also, the present solar cell comprises 16-20 silicon wafers no bigger than 120mm, forming a parallel circuit with a total electric resistance less than 100 $\Omega$.

The spectrum converter 20 is processed to be the form of a thin polymer layer, in which an inorganic fluorescent powder 21, for example but not limited to super-dispersion inorganic fluorescent particle, is filled therein and which is contacted with the outer surface of the monocrystalline silicon wafer 10. The inorganic powder 21 can enhance the absorption for a first specific range of wavelength, for example but not limited to, the solar radiation of 300-580 nm, and re-radiate them to a second specific range of wavelength, for example but not limited to, 580-760 nm. The polymer thin film of the spectrum converter 20 is an organic polymer with average polymerization of m=100-500 and a molecular mass of 10000-20000 standard atomic mass unit. Furthermore, the spectrum converter 20 can further contain epoxy (not shown) to raise the ability to convert light.

The substrate of the inorganic fluorescent powder 21 is, for example but not limited to, yttrium gadolinium garnet, formulated as $(Y,Gd)_3Al_{5-x}(Mg,Si)_xO_{12}(x=0\sim3)$. One or two of $Ce^{+3}$, $Cr^{+3}$, and $Fe^{+3}$ are taken as exciting agents, which can be excited by visible yellow, orange, red, and dark red lights in the wavelength range of 300-580 nm and re-radiated to form broadband radiation of half-width $\Delta\lambda_{0.5}>110$ nm and/or narrow-band radiation of $\Delta\lambda=20\sim40$ nm, wherein the peak radiation is shifted to 640-760 nm. The radiation is largely absorbed by the p-type monocrystalline silicon wafer of a total thickness of 100-300 $\mu$m.

The ratio of yttrium and gadolinium ions in the inorganic fluorescent powder 21 using yttrium gadolinium garnet as its substrate varies at the range of Y:Gd=2.8:0.2~1:2, and the ratio increases as the peak radiation of exciting ions

$Ce^{+3}$, $Cr^{+3}$, or $Fe^{+3}$ moves; the optimum concentration of these ions between 0.005-0.05%. In the yttrium gadolinium garnet, the molar ratio of magnesium oxide and silicon oxide is $MgO : SiO_2 = 1 \pm 0.02$ to ensure the peak radiation of the inorganic fluorescent powder 21 shifting 20-40 nm toward long wavelengths.

The spectrum converter 20 is an oxygen-containing polymers comprising mainly polycarbonate and/or polysiloxanes and/or acrylatepolymer, which is filled with fluorescent powder particle using garnet-structure oxides of elements of the II, III, and IV groups in the period table, wherein the particles has a diameter less than the peak wavelength (d < d $\lambda_{Max}$), and its content in the polymer is 1-50%. Furthermore, the color of the outer surface of the spectrum converter is orange and has an absorptivity higher than 60% to the lights in the wavelength range of 300-520 nm. In addition, the quantum radiance of the spectrum converter 20 ranges between 76~96%, increasing as the thickness of the thin film increases over the range 0.1~0.5mm; the total reflectivity of the thin film for the natural light absorbed by a solar cell is 4~6%.

The spectrum converter 20 made of polycarbonate thin film with a molar mass of m=12000 atomic mass unit, wherein the volume concentration of the fluorescent powder 21 is 30% with a composition of $(Y,Gd)_3Al_{5-x}(Mg,Si)_xO_{12}$: Ce(2%) Cr(0.1%) Fe(0.05%).

The physics principle of the solar cell according to the present invention is described below. First, the reason to choose polycarbonate and/or polysiloxanes and/or acrylatepolymer rather than any other polymers as the material of the spectrum converter 20 is that these polymers have great transparency over the range of the broadband wavelength $\lambda$=400~1200 nm. Furthermore, the polymer described above has a higher damage threshold for the short wavelength solar radiation.

The main characteristics of the spectrum converter 20 is manifested by comprising the inorganic fluorescent powder 21 particles made of the oxides of the elements of Group II, III, and IV, and the crystal structure of the oxides is a cubic garnet. In addition, the diameter of the inorganic fluorescent powder is shorter than the wavelengths of the solar radiation which excite it, thereby completely changing the scattering rule (in this case the Raleigh's Law obeys the Mie rule) of fluorescent powder particle 21. To render the emission spectrum and the solar spectrum overlapped, the filling ratio of the fluorescent powder particle 21 inside the spectrum converter 20 should be in the range of 1-50%. The spectrum converter 20 is usually produced by dissolving the polymer into organic solvents, such as dichloromethane or trichloroethylene, and using casting method to produce the polymer thin layer.

The transparency rate of the spectrum converter 20 at the thickness of 80~100 $\mu$m can reach 85% (under perpendicular incidence) since no scattering or insignificant scattering occurs in the powder; the orange light will appear in the transmission light.

The characteristic of the solar cell with the new spectrum converter 20 arises from the inorganic fluorescent powder using iron-contained yttrium gadolinium garnet as its substrates, formulated as $(Y,Gd)_3(Al,Fe)_3(Mg,Si)_2 O_{12}$, which is excited by one of $Ce^{+3}$, $Cr^{+3}$, and $Fe^{+3}$ or three of them to induce d-d transition in the powder, which in turn emits radiations.

In an example of the present invention, the spectrum converter is prepared as follows:

Prepare oxide compounds $Gd_2O_3$-27.15g, $Y_2O_3$-16.95g, $CeO_2$-1.7g, $Al_2O_3$-31.2g, $SiO_2$-3g, and $MgO_2$-2g, and then put the prepared oxide compounds into a 500ml quarts crucible and mix them well.

Thereafter, put the 500ml quarts crucible in an $NH_3$ type ($N_2$;$H_2$=3:1) atmosphere furnace, and then heat to 450°C at speed 5°C/minute and keep at this temperature for 1 hour, and then heat to 1200°C at speed 5°C/minute and keep at this temperature for 3 hour, and then heat to 1500°C at speed 5°C/minute and keep at this temperature for 4 hour, and then lower the temperature to room temperature at speed 5°C/minute, and then remove the 500ml quarts crucible from the $NH_3$ type (N2;$H_2$=3:1) atmosphere furnace after reached room temperature.

The powder thus obtained is then washed with nitric acid (at ratio 1:1) and phosphoric acid (1: 1), and then repeatedly wash the powder with clean water till the neutralized status.

The well-washed powder is then dried in a T=120°C baking oven. The dried powder thus obtained is the desired finished spectrum converter.

First of all, the reason of choosing the fluorescent powder with cubic garnet structure is that the structure is compatible with the d-d electron transition center of, for example, $Ce^{+3}$,$Cr^{+3}$,and $Fe^{+3}$. From the experimental results of the present invention, the best light intensity emitted from the cubic garnet fluorescent powder 21 excited by $Ce^{+3}$, $Cr^{+3}$, and $Fe^{+3}$ is the 1~3 % filling concentration of the fluorescent powder 21. When compared with the amount of the excited d-d transition, the content of the garnet-type two chips structure is relatively high. Second, the aforementioned chemical formula provides two methods to move the radiations emitted from the fluorescent powder 21 toward longer wavelengths:

1. Partial replace Y ions with Gd ions, and the radiations of $Ce^{+3}$, $Cr^{+3}$, and $Fe^{+3}$ shift toward longer wavelength range, 535~590 nm, 695~710 nm, 680~780 nm, respectively;

2. Using paired ions, ($Mg^{+2}$ and $Si^{+4}$), or ($Ca^{+2}$ and $Ge^{+4}$), or ($Sr^{+2}$ and $Sn^{+4}$), for example, to replace $Al^{+3}$ in the anion crystal lattice.

The effect of the first method is gradual and slow, in which the radiation spectrum is moved gradually toward longer wavelength; the peak radiation shifts 1 nm per 1% Y ions replaced by 1% Gd ion.

In the second said method, two $Al^{+3}$ are replaced by a $Mg^{+2}$ and a $Si^{+4}$, yielding a sudden change. As the fluorescent powder 21 excited by the $Ce^{+3}$, the peak radiation wavelength shifts 35 nm per pair of $Al^{+3}$ replaced with a $Mg^{+2}$ and a $Si^{+4}$.

The two ways of shifting short radiation to long wavelength differ in the coordination numbers of the replaced ions. The coordination number of Gd ion is 8-12, while that of Al ion is 4-6. The surrounding of an ion with greater coordination number is changed more slowly; for the Al ion anion lattice with smaller coordination number, doping smaller sizes $Mg^{+2}$ and $Si^{+4}$ will result in sudden change in the lattice force field. According to the experimental results of the present invention, the solar cell using silicon wafer can enhance the absorption of the radiation of the spectrum converter. The reflection ratio of the light emitting on the surface of the spectrum converter is not more than 0.5-1%, which is the advantage of the fluorescent powder 21 according to the present invention. This fluorescent powder 21 is characterized in using cubic garnet yttrium gadolinium compound as substrate with the ratio of yttrium and gadolinium as Y:Gd = 2.8: 0.2 - 1:2, which varies as the shifting peak radiation of exciting ions $Ce^{+3}$ and/or $Cr^+$. The optimum concentrations of the ions in the fluorescent powder 21 are 0.005~0.05%.

The concentrations of $Mg^{+2}$ and $Si^{+4}$ in the fluorescent powder of aluminum yttrium compound according to the change of the chemical formula listed below:

$$(Y,Gd)_3Al_5O_{12}:Ce(Cr,Fe)$$

$$(Y,Gd)_3Al_{4.5}Mg_{0.25}Si_{0.25}O_{12}: Ce(Cr,Fe)$$

$$(Y,Gd)_3Al_4Mg_{0.5}Si_{0.5}O_{12}: Ce(Cr,Fe)$$

$$(Y,Gd)_3Al_{3.5}Mg_{0.75}Si_{0.75}O_{12}: Ce(Cr,Fe)$$

$$(Y,Gd)_3Al_{3.0}Mg_{1.0}Si_{1.0}O_{12}: Ce(Cr,Fe)$$

$$(Y,Gd)_3Al_{2.0}Mg_{1.5}Si_{1.5}O_{12}: Ce(Cr,Fe)$$

The different-valence replacement of $Al^{+3}$ with $Mg^{+2}$ and $Si^{+4}$ differs from the same-valence replacement of Y and Gd, wherein $Al^{+3}$ replaced with $Mg^{+2}$ will form a $(Mg_{Al})'$ center with negative charges equivalent to the positive charge of the $(Si_{A1})'$ center formed by replacing $Al^{+3}$ with $Si^{+4}$, i.e., $(Mg_{Al})'=(Si_{A1})'$. This requires the equivelence of Mg and Si atoms in the chemical formula of the garnet crystal. However, it is discovered experimentally that when the difference between the numbers of Mg or Si atom and Si or Mg, respectively, less than $\pm 0.02$, the radiation spectrum emitted will shift toward longer wavelength by 20-40 nm. According to the experimental results of the present invention, the improved fluorescent powder based on the principles described above is characterised by the molar mass of magnesium oxide and Silicon being $MgO:SiO_2=1\pm0,02$, and thus the peak radiation of the fluorescent powder shifts toward longer wavelength by 20-40 nm.

The new fluorescent powder 21 of Al, Si-doped garnet-structure yttrium gadolinium according to the present invention can be produced by the solid-phase synthesis in weak reduction and high temperature environment often adopted in industry. The raw material used includes yttrium oxide (99.99% purity), gadolinium oxide, magnesium oxide, silicon, aluminum oxide (99.95% purity), cerium oxide, and chromium oxide (99.9% purity); the detailed compositions are shown in Table 1.

Table 1: The characteristics of fluorescent powder used as the spectrum converter

| No. | Compositions of Fluorescent Powder | Peak wavelength, nm | Half-width Peak wavelength ,nm | Photon radiation ratio, % |
|---|---|---|---|---|
| 1 | $Y_{1.5}Gd_{1.5}Al_5O_{12}:Ce_{0.02}$ | 560 | 120 | 92 |
| 2 | $Y_{1.5}Gd_{1.7}Al_5O_{12}:Ce_{0.02}, Cr_{0.005}$ | 580, 700 | 125,10 | 86 |
| 3 | $Y_{1.3}Gd_{1.7}Al_5O_{12}:Ce, Fe_{0.005}$ | 585, 746 | 140 | 88 |
| 4 | $Y_{1.3}Gd_{1.7}Al_5O_{12}: Fe$ | 740 | 60 | 60 |

(continued)

| No. | Compositions of Fluorescent Powder | Peak wavelength, nm | Half-width Peak wavelength ,nm | Photon radiation ratio, % |
|---|---|---|---|---|
| 5 | $Y_{1.5}Gd_{1.5}Al_{4.5}Mg_{0.25}Si_{0.25}O_{12}$:Ce | 600 | 125 | 75 |
| 6 | $Y_{1.5}Gd_{1.5}Al_4Mg_{0.5}Si_{0.5}O_{12}$:Ce | 640 | 140 | 80 |
| 7 | $Y_{1.5}Gd_{1.5}Al_3Mg_{1.0}Si_{1.0}O_{12}$:Ce,Fe | 660, 750 | 160 | 80 |
| 8 | $Y_{1.5}Gd_{1.5}Al_2Mg_{1.5}Si_{1.5}O_{12}$:Ce,Fe | 680-780 | 160-180 | 85 |
| 9 | $Y_{1.5}Gd_{1.5}Al_2(MgSi)_3O_{12}$:Ce, Cr,Fe | 680-745, 780 | 160-200 | 85-90 |
| 10 | $Al_2O_3$:Cr(0.7%) | 694 | 10 | 75 |

The two methods of replacing the major ions (Y↔Gd, Al→Mg+Si) in the garnet lattice change the peak wavelength of fluorescent powder using $Cr^{+3}$ as its active center to the wavelength of 580-780 nm, wherein there's no loss of photons emitted by the radiation of the fluorescent powder. The absorption spectrum shows that all the materials described above can greatly absorb radiations in the range of visible light since the mixed powder shows the colors of yellow, orange, or even pale red. Because the fluorescent powder has a bright color, it is often used in reducing the reflection coefficient on the outer surface of a solar cell, thereby reducing the requirement for the outer structure of the solar cell. Modern technology often applies coating on the silicon wafer surface with $Si_3N_4$ thin film to have the surface shining. However, the technical difficulty of the manufacturing process raises the cost of a solar cell. Consequently, the fully colored fluorescent powder can reduce the cost of a solar cell.

The spectrum converter 20 according to the present invention of can be produced in the two different methods as described below.

1. Cast the polymer suspension solution over the surface of the single crystalline silicon wafer 10. The thin film of the spectrum converter 20 produced by this method has the same size with the silicon wafer 10. The concentration of the fluorescent powder particle 21 in the polymer suspension solution is 5-50%. It is also important that when the concentration of powder particle 21 is low, it is necessary to increase the thickness of the polymer thin film; on the other hand, when the concentration of powder particle 21 is high, the thickness of the polymer thin film can be reduced to 20~60μm. In such a circumstance, the spectrum converter 20 can absorb 60~90% lights emitted on its surface, thereby ensuring high luminescence efficiency and photon radiation efficiency. The solar cell with the advantage described above results in the color of the spectrum converter 20 being orange and thus the absorbability is greater than 60% for the radiation between 300~520 nm. Meanwhile, the photon radiation efficiency is 75~96%, which increases as the thickness of polymer thin film increases between 0.1~0.5 mm. The reflection ratio of the light emitting on the surface of the spectrum converter 20 is 4~6%.

Furthermore, the spectrum converter 20 has the following characteristics as follows. First, the average polymerization of the organic polymer forming the spectrum converter 20 reaches 100-500, thereby ensuring its molecular weight close to 10000~20000 standard atomic mass units. The smaller molecular weight resulted from the reduced degree of polymerization will produce a hard polymer thin film with a poor plasticity. On the other hand, increasing the degree of polymerization will reduce the transparency of the polymer, leading to a lower efficiency of a solar cell.

Moreover, during the process of the present invention it is discovered that the best method of producing the spectrum converter 20 is to dissolve the polycarbonate in $CH_2Ch$ to form a 20% solution and then cast the solution. Meanwhile the molecular weight of polycarbonate will be 12000 standard atomic mass units. The best filling concentration is 20% for the fluorescent powder particle 21 whose chemical formula is $(Y,Gd)_3Al_{5-x}(Mg,Si)_x O_{12}$:Ce(2%)Fe(0.05%)Cr (0.1%) and whose average diameter is 0.6μm,. The thickness of the polymer thin film cast with the spectrum converter on the surface of silicon wafer is 60±5 μm. Then, several single crystalline silicon wafers 10 coated with the spectrum converter 20 are assembled as a solar cell.

Apart from the aforementioned casting method, the inventors have also tried to extrude polythene as the spectrum converter 20 under the high temperature of 190°C. The prior art of the extrusion of polythene film has been described in the aforementioned patent and will not be discussed here again. It is worth noting that the concentration of the fluorescent powder in the thin film is 18% with a specific chemical composition as low-concentrated polythene 62%, EVA 20%, and fluorescent powder 18%. The polythene film has a thickness of 120±10μm and a high homogeneity and toughness. The polythene film containing fluorescent powders is then glued using a special adhesive onto the surface of silicon wafer.

The following description is about the whole structure of a solar cell. In general, a solar cell comprises a set of silicon wafers arranged in a parallel circuit, wherein the number of silicon wafers is determined by the geometric dimension of the single crystalline silicon wafer 10. Table 2 below shows the specification parameters of the single crystalline silicon wafer 10. The area of the cross section of the silicon bar is a pseudo rectangular (a square with its corners being cut) is $125\times125\pm0.5$ mm$^2$, wherein the silicon wafer has a standard thickness of $300\pm30\mu$m. Because the silicon wafer has a larger mass (>25g), the cost of a single crystalline silicon wafer 10 required in a multi-purpose solar cell is therefore increased. Consequently, the present invention employs a silicon wafer of smaller thickness (thickness 1=$240\pm25\mu$m) is used and thus the cost is cut down by 20%. Meanwhile, the fluctuation of electric resistance is very small and thus the silicon wafer of smaller thickness is more easily to be connected with a solar cell. The area of a solar cell has is usually 0.25 m$^2$, comprising 16 single crystalline silicon wafers. Under few circumstances, a solar cell for large instruments may require 64 or 144 pieces of the single crystalline silicon wafer 10.

Table 2

| 1 | Growth method | Czochralski techique |
|---|---|---|
| 2 | Dopants | boron |
| 3 | Conductive type | P-type |
| 4 | Electric resistance ratio | 0.5~3.0Ω/mm |
| 5 | Diameter | $150\pm0.5\mu$m |
| 6 | Location | $100\pm2$ degrees |
| 7 | Minority Carrier lifetime | > 10 μsec |
| 8 | Dislocation density | <10/mm$^2$ |
| 9 | Oxygen content | 1*1018 atom(s)/mm$^3$ |
| 10 | Carbon content | 5*1017 atom(s)/mm$^3$ |
| 11 | Diagonal | $150\pm1$mm |
| 12 | Silicon wafer planar size | 125.0*125.0$\pm$0.5mm |
| 13 | W, X, Y, Z symmetry | 20.3-21.9mm |
| 14 | Square center | $\leqq0.3$mm |
| 15 | Perpendicularity and parallelity | <0.5mm |
| 1 6 | Arris position | (010),(001) |
| 17 | Thickness | $300\pm30$mm |
| 18 | Thickness variation range | <30 mm |
| 19 | Flexuosity | <50 mm |
| 20 | Silicon wafer surface position | $100\pm3$ degree |
| 21 | Visible fault on surface | <20 mm |
| 22 | Visible scar by cutting | <5 mm |
| 23 | Border quality | Allowing no more than two gaps of length<1 mm, depth<0.3mm and No cracking. |

While using the single crystalline silicon wafers 10 to assemble a solar cell, the present invention also tried to use multi-crystalline silicon to make a solar cell. Multi-crystalline silicon is made into a thin film and placed under the metal conductive base. In term of physical properties, the carrier activity in multi-crystalline silicon is poor than that in single crystalline silicon; however, multi-crystalline silicon has a lower cost than its single crystal counterpart.

According to the experiments of the present invention, the worst efficiency of all the single crystalline silicon solar cells having the spectrum converter 20 is 15% (compared with the efficiency of a conventional solar cell is about 13.5%), and the corresponding output voltage is 0.600watt and short-circuit current is 4.70 ampere. The aforementioned experiments provide a unequivocal evidence that the solar cell having spectrum converter 20 has surpassed conventional solar cells.

The solar cell with the spectrum converter according the present invention can enhance the converting efficiency of a single crystalline silicon wafer in the wavelength range between 380~550 nm, which has higher solar radiation energy; consequently, the overall converting efficiency of a solar cell can be enhanced, and it is thus favorably compared with conventional solar cells.

In summary, the solar cell using the spectrum converter according to the present invention, has a spectrum converter which is processed to have a polymer thin film filled with the super-dispersion inorganic fluorescent powder; the thin film is in a direct contact with the outer surface of the p-type single crystalline silicon wafer. The technical configuration is characterized by its ability to convert more than 16% solar energy into electricity, thus it can indeed improve the drawbacks of conventional solar cells.

While the invention has been described with reference to the a preferred embodiment thereof, it is to be understood that modifications or variations may be easily made without departing from the spirit of this invention, which is defined by the appended claims.

**Claims**

1. A solar cell, comprising:

   a silicon wafer to accommodate the spectrum converter described later, and
   a spectrum converter manufactured to be a polymer thin film, wherein the polymer thin film is filled with inorganic fluorescent powder and in contact with the outer layer of the silicon wafer, which can enhance the absorption of a first specific wavelength of solar radiation and re-radiate into a second specific wavelength of radiation.

2. The solar cell as defined in claim 1, wherein the silicon wafer is a p-type monocrystalline silicon wafer, a p-type polycrystalline silicon wafer, a n-type monocrystalline silicon wafer, or a n-type polycrystalline silicon wafer.

3. The solar cell as defined in claim 1, wherein the inorganic fluorescent powder is inorganic fluorescent super-dispersion particle.

4. The solar cell as defined in claim 1, wherein the first specific range of wavelength is 300-580 nm, and the second specific range of wavelength is 580-760 nm.

5. The solar cell as defined in claim 1, wherein the spectrum converter can further be filled with epoxy.

6. The solar cell as defined in claim 1, wherein the spectrum converter is an oxygen-containing polymers comprising mainly polycarbonate and/or polysiloxanes and/or acrylatepolymer, which is filled with fluorescent powder particle using garnet-structure oxides of elements of the II, III, and IV groups in the period table, and the fluorescent particle has a diameter less than the peak wavelength ($d < d \lambda_{Max}$) and its content in the polymer is 1-50%.

7. The solar cell as defined in claim 1, wherein the chemical composition of the inorganic fluorescent powder is $(Y, Gd)_3Al_{5-x}(Mg,Si)_xO_{12}$ (x=0~3), and one or two of $Ce^{+3}$, $Cr^{+3}$, and $fe^{+3}$ are taken as exciting agents, which can be excited by visible yellow, orange, red, and dark red lights in the wavelength range of 300-580 nm and re-radiated to form broadband radiation of half-width $\Delta\lambda_{0.5}>110$ nm and/or narrow-band radiation of $\Delta\lambda= 20\sim 40$ nm with the peak radiation being shifted to 640-760 nm and the radiation being largely absorbed by the p-type monocrystalline silicon wafer of a total thickness of 100-300$\mu$m.

8. The solar cell as defined in claim 7, wherein the ratio of yttrium and gadolinium ions in the inorganic fluorescent powder using yttrium gadolinium garnet as its substrate varies at the range of Y:Gd=2.8:0.2~1:2, and the ratio increases as the peak radiation of exciting ions $Ce^{+3}$, $Cr^{+3}$, or $Fe^{+3}$ moves, and the optimum concentration of these ions is between 0.005-0.05%.

9. The solar cell as defined in claim 7, wherein the molar ratio of magnesium oxide and silicon oxide in the yttrium gadolinium garnet is $MgO : SiO_2 = 1 \pm 0.02$ to ensure the peak radiation of the inorganic fluorescent powder shifting 20-40 nm toward long wavelengths.

10. The solar cell as defined in claim 1, wherein the color of the outer surface of the spectrum converter is orange and has an absorptivity higher than 60% to the lights in the wavelength range of 300~520 nm.

11. The solar cell as defined in claim 1, wherein the quantum radiance of the spectrum converter 20 ranges between 76~96%, increasing as the thickness of the thin film increases over the range 0.1~0.5mm and the total reflectivity of the thin film for the natural light absorbed by a solar cell is 4~6%.

12. The solar cell as defined in claim 1, wherein the polymer thin film is an organic polymer with average polymerization of m=100-500 and a molecular mass of 10000-20000 standard atomic mass unit.

13. A spectrum converter used in a solar cell is a polymer thin film made of inorganic powders, which is in contact with the outer surface of a monocrystalline silicon wafer, to enhance the absorption of a first specific wavelength of solar radiation and re-radiate into a second specific wavelength of radiation.

14. The solar cell as defined in claim 13, wherein the silicon wafer is a p-type monocrystalline silicon wafer, a p-type polycrystalline silicon wafer, a n-type monocrystalline silicon wafer, or a n-type polycrystalline silicon wafer.

15. The solar cell as defined in claim 13, wherein the inorganic fluorescent powder is inorganic fluorescent super-dispersion particle.

16. The solar cell as defined in claim 13, wherein the first specific range of wavelength is 300-580 nm, and the second specific range of wavelength is 580-760 nm.

17. The solar cell as defined in claim 13, wherein the spectrum converter is an oxygen-containing polymers comprising mainly polycarbonate and/or polysiloxanes and/or acrylatepolymer, which is filled with fluorescent powder particle using garnet-structure oxides of elements of the II, III, and IV groups in the period table, and the fluorescent particle has a diameter less than the peak wavelength ($d < d\ \lambda_{Max}$) and its content in the polymer is 1-50%.

18. The solar cell as defined in claim 13, wherein the chemical composition of the inorganic fluorescent powder is $(Y, Gd)_3Al_{5-x}(Mg,Si)_xO_{12}(x=0\sim3)$, and one or two of $Ce^{+3}$, $Cr^{+3}$, and $Fe^{+3}$ are taken as exciting agents, which can be excited by visible yellow, orange, red, and dark red lights in the wavelength range of 300-580 nm and re-radiated to form broadband radiation of half-width $\Delta\lambda_{0.5}>110$ nm and/or narrow-band radiation of $\Delta\lambda$= 20- 40 nm with the peak radiation being shifted to 640-760 nm and the radiation being largely absorbed by the p-type monocrystalline silicon wafer of a total thickness of 100-300$\mu$m.

19. The solar cell as defined in claim 13, wherein the ratio of yttrium and gadolinium ions in the inorganic fluorescent powder using yttrium gadolinium garnet as its substrate varies at the range of Y:Gd=2.8:0.2~1:2, and the ratio increases as the peak radiation of exciting ions $Ce^{+3}$, $Cr^{+3}$, or $Fe^{+3}$ moves, and the optimum concentration of these ions is between 0.005-0.05%.

20. The solar cell as defined in claim 13, wherein the molar ratio of magnesium oxide and silicon oxide in the yttrium gadolinium garnet is $MgO : SiO_2 == 1 \pm 0.02$ to ensure the peak radiation of the inorganic fluorescent powder shifting 20-40 nm toward long wavelengths.

21. The solar cell as defined in claim 13, wherein the spectrum converter made of polycarbonate thin film with a molar mass of m=12000 atomic mass unit, and the volume concentration of the fluorescent powder is 30% with a composition of $(Y,Gd)_3Al_{5-x}(Mg,Si)_xO_{12}$:Ce(2%) Cr(0.1%) Fe(0.05%).

(PRIOR ART)

FIG. 1

SPECTRAL RESPONSE

FIG. 2

FIG. 3

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Thin Film Solar Cells. World Publish Ltd, 378-379